# EUROPEAN PATENT APPLICATION

(11) **EP 3 176 854 A1**
(43) Date of publication of application: **07.06.2017**
(21) Application number: 15197704.8
(22) Date of filing: 03.12.2015
(51) Int. Cl.: H01M 2/14, H01M 10/42, H01M 10/48

(54) **BATTERY CELL**

(71) Applicant: Lithium Energy and Power GmbH & Co. KG, 70469 Stuttgart (DE)
(72) Inventor: Gansemer, Michael, 74366 Kirchheim (DE); Fakhri, Morteza, 70437 Stuttgart (DE)
(74) Representative: Bee, Joachim

(57) **Abstract**

The invention refers to a Battery cell (2), comprising at least one electrode assembly (10), containing an anode (11) and a cathode (12) that are divided from one another by means of a separator layer (18), and at least one sensor element (30) for detecting defects in the electrode assembly (10). The least one sensor element (30) is at least partially integrated in the separator layer (18).

## Description

The invention relates to a battery cell, comprising at least one electrode assembly, containing an anode and a cathode that are divided from one another by means of a separator layer. The battery cell also comprises at least one sensor element for detecting defects in the electrode assembly.

### State of the Art

Electrical energy can be stored by means of batteries. Batteries change chemical energy into electrical energy. Particularly, rechargeable batteries are known that can be charged and discharged several times. Batteries or battery systems comprise several battery cells that are connected electrically in series or in parallel.

Especially, lithium ion battery cells are used in rechargeable batteries or battery systems. Lithium ion battery cells have a relatively high energy density. Lithium ion battery cells are used for instance in motor vehicles, in particular in electric vehicles (EV), in hybrid electric vehicles (HEV) and in plug-in hybrid vehicles (PHEV). Lithium ion battery cells may comprise one or more electrode assemblies.

Electrode assemblies have a positive electrode called cathode and a negative electrode called anode. The anode and the cathode are divided from one another by means of a separator. The electrodes of the battery cell are formed like foils and are wound with interposition of the separator to form an electrode roll, also referred to as jelly-roll. Alternatively, the electrodes can be layered to form an electrode stack.

The electrodes and the separator are surrounded by an electrolyte that is normally in liquid state or in solid state. The electrodes of the electrode assemblies are connected to terminals of the battery cell. The battery cell can be charged and discharged by means of the terminals.

The cathode and the anode each comprise a current collector on which an active material is applied. The current collector of the cathode is typically made of aluminium and the current collector of the anode is typically made of copper. The active material for the cathode is, for example, a metal oxide. The active material for the anode is, for example, graphite or silicon. In the active material of the anode lithium atoms are intercalated.

In a discharging process, electrons flow in an external circuit from the anode to the cathode, and lithium ions move within the battery cell from the anode to the cathode. In a charging process of the battery cell, the lithium ions move from the cathode to the anode. Thereby, the lithium ions are stored back into the active material of the anode reversibly.

For safe operation of a battery cell, it is necessary to monitor technical parameters of the battery cell. Said parameters include, inter alia, a voltage applied to the terminals, a current flowing through the battery cell, and a temperature of the battery cell. For determining parameters, corresponding sensors are provided within the battery cell.

In case of a local short circuit within a battery cell, a thermal runaway may occur, which may destroy the battery cell. Therefore, it is necessary to detect such a short circuit early before the battery cell is destroyed. Such a short circuit may originate for example by growth of a dendrite or by conducting particles between the electrodes.

Document DE 10 2012 209 397 A1 discloses a battery cell with an internal pressure sensor which is designed as a film and is located between the electrode coil and a housing of the battery cell. The sensor has resistive, capacitive, piezoresistive and piezoelectric functional elements. An electrode terminal may act as a signal interface.

Document WO 2012/097956 A1 A1 discloses a battery cell having an electrode unit and several sensors. The sensors are used, inter alia, to measure a temperature of the battery cell. The sensors are aligned in a matrix-like arrangement.

Document Journal of Power Sources, 260, 43-49 (2014), "In-situ temperature measurement in lithium ion battery by transferable flexible thin film thermocouples" by Santosh et al. describes methods for local measuring of relevant parameters within a battery cell, in particular for temperature measurement.

### Disclosure of the Invention

The invention refers to a battery cell, comprising at least one electrode assembly, containing an anode and a cathode that are divided from one another by means of a separator layer, and at least one sensor element for detecting defects in the electrode assembly. Such a defect is in particular a local short circuit within the battery cell between the anode and the cathode. Said local short circuit generates several effects, in particular a rise of temperature in a local area around the short circuit.

According to the invention, the least one sensor element is at least partially integrated in the separator layer. Hence, the sensor element is placed directly between the anode and the cathode and therefore very close to the defect. The sensor element can, for example, be inserted into the material of the separator layer. Thus, the sensor element is completely surrounded by the material of the separator layer. The sensor element can also be arranged such that a part of the sensor element protrudes over the material of the separator layer. Thus, only a fraction of the sensor element is surrounded by the material of the separator layer.

According to a further development of the invention, a plurality of sensor elements is aligned in a matrix-like sensor arrangement. That means, several sensor elements are arranged in the battery cell and every single sensor element can detect a defect in immediate proximity. Hence, a local measurement within the battery cell is possible and a detected defect can be localized.

According to an advantageous embodiment of the invention, an evaluation unit for evaluating measurement data received from the sensor elements is arranged on the separator layer. Said evaluation unit may comprise a logical or electronical circuit. The evaluation unit receives measurement values from the single sensor elements and executes a pre-processing. Hence, the received measurement values can be checked for plausibility and the amount of data that is transmitted to a global control unit can be reduced.

Preferably, the at least one sensor element is a thermal sensor sensing temperature in the electrode assembly. When such a thermal sensor detects a local rise of temperature, this may be an indication of a defect, in particular a short circuit, in proximity of the sensor element.

Alternatively, the at least one sensor element is a capacitive sensor sensing electrical field in the electrode assembly. In particular, the capacitive sensor includes two electrode plates that are arranged on adjacent sides of the separator layer. Thus, the separator layer represents a dielectric within a capacitor and is a part of the sensor element. Hence, the electrode plates may protrude over the separator layer and the dielectric is integrated in the separator layer. In absence of a defect, an approximately homogeneous electrical field is present between the electrode plates and a constant capacity is measurable. In case of a defect in proximity of the sensor element, the electrical field is getting inhomogeneous and the capacity is changing. When such a capacitive sensor detects a local change of capacity, this may be an indication of a defect, in particular a short circuit, in proximity of the sensor element.

Alternatively, the at least one sensor element is a piezoelectric sensor sensing force in the electrode assembly. The piezoelectric sensor may be completely integrated in the material of the separator layer or may protrude over the separator layer. When such a piezoelectric sensor detects a pressure or force, this may be an indication of a defect, in particular an expansion of an active material of the anode or the cathode. For example, this can be a locally growing dendrite in proximity of the sensor element.

According to a further development of the invention, at least one actuator element for generating defects in the electrode assembly is at least partially integrated in the separator layer. Hence, the actuator element is placed directly between the anode and the cathode. The actuator element can, for example, be inserted into the material of the separator layer. Thus, the actuator element is completely surrounded by the material of the separator layer. The actuator element can also be arranged such that a part of the actuator element protrudes over the material of the separator layer. Thus, only a fraction of the actuator element is surrounded by the material of the separator layer. A battery cell with such an actuator element is in particular usable in a test laboratory for testing sensor elements provided in the electrode assembly.

According to an advantageous embodiment of the invention, a plurality of actuator elements is aligned in a matrix-like actuator arrangement. That means, several actuator elements are arranged in the battery cell and every single actuator element can generate a local defect. Hence, testing of the local sensor elements within the battery cell is possible.

Preferably, the at least one actuator element is a transistor actuator generating a shortcut within the electrode assembly. The transistor actuator may be almost completely integrated in the material of the separator layer with electrode areas extending to adjacent surfaces of the separator layer. When the transistor actuator is activated, the transistor actuator represents a local short circuit.

Alternatively, the at least one actuator element is a piezoelectric actuator generating force within the electrode assembly. The piezoelectric actuator may be completely integrated in the material of the separator layer or may protrude over the separator layer. Such a piezoelectric actuator can generate a local pressure or a local force on the active material of the anode or the cathode. For example, this can simulate a locally growing dendrite.

A battery cell according to the invention is usable advantageously in an electric vehicle (EV), in a hybrid electric vehicle (HEV), in a plug-in hybrid vehicle (PHEV) or in a test or development laboratory.

### Advantages of the Invention

The battery cell according to the invention permits local measuring of relevant parameters within a battery cell, in particular temperature, electrical field or force for detecting defects in the electrode assembly of the battery cell. In particular, when a matrix-like sensor arrangement is used, locally dissolved measurement within the battery cell is possible and a detected defect can be localized. By integrating the sensor element into the separator layer, the sensor element does not require additional space within the battery cell. When the material of the separator is usable as part of the sensor element, the amount of additional required material for the sensor element is also reduced. Furthermore, the sensor element is placed directly between the anode and the cathode and therefore very close to the defect to be detected.

The actuator element permits generating defects in the electrode assembly as means for testing the provided sensor elements. According to the kind of sensor element which is provided, different kinds of defects can be generated. Hence, the battery cell comprising an actuator element is in particular usable in a test laboratory for testing sensor elements provided in the electrode assembly of the battery cell. By integrating the actuator element into the separator layer, the actuator element does not require additional space within the battery cell.
In particular, when a matrix-like actuator arrangement is used, locally dissolved generating of defects within the battery cell is possible and selected sensor elements can be tested.

### Brief Description of the Drawings

For a better understanding of the aforementioned embodiments of the invention as well as additional embodiments thereof, reference should be made to the description of embodiments below, in conjunction with the appended drawings showing:
- Figure 1: a schematic view at a battery cell,
- Figure 2: a schematic view at a sensor arrangement,
- Figure 3: a schematic sectional view at a thermal sensor,
- Figure 4: a schematic sectional view at a capacitive sensor,
- Figure 5: a schematic sectional view at a piezoelectric sensor,
- Figure 6: a schematic sectional view at a transistor actuator and
- Figure 7: a schematic sectional view at a piezoelectric actuator.

Hereinafter, preferred embodiments of the present invention will be described with reference to the drawings. The drawings only provide schematic views of the invention. Like reference numerals refer to corresponding parts, elements or components throughout the figures, unless indicated otherwise.

### Description of Embodiments

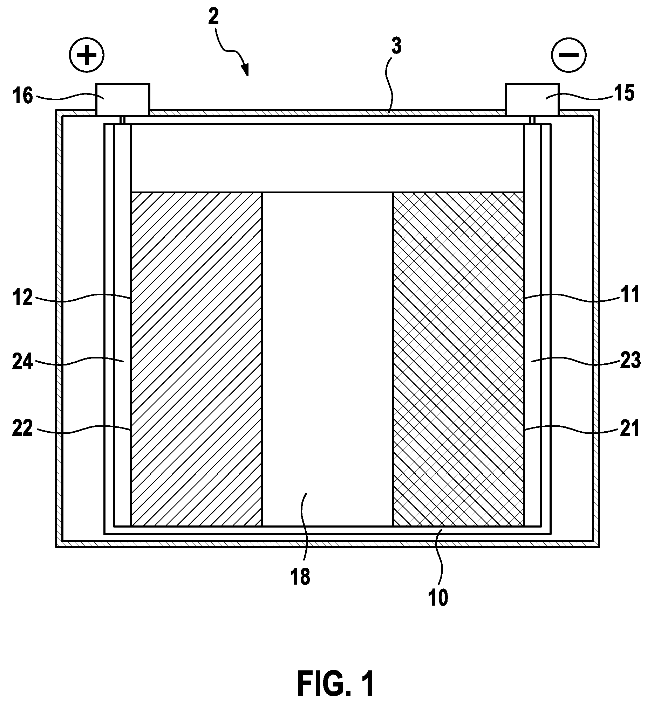

Figure 1 shows a schematic view at a battery cell 2. The battery cell 2 contains a housing 3 which has, for example, a prismatic or a cylindrical shape. The battery cell 2 further contains an electrode assembly 10, which is arranged within the housing 3. The electrode assembly 10 contains an anode 11, a cathode 12 and a separator layer 18 that is arranged between the anode 11 and the cathode 12. Furthermore, the battery cell 2 contains a negative terminal 15 and a positive terminal 16. The terminals 15, 16 serve for charging and discharging the battery cell 2 and are mounted on the housing 3.

Presently, the electrode assembly 10 is shaped as a jelly roll. That means the anode 11 and the cathode 12 of the electrode assembly 10 are flat foils that are wound about an axis. The separator layer 18 that is also a flat foil is wound between the anode 11 and the cathode 12 about the same axis. The separator layer 18 is made of an electrically insulating material.

The electrode assembly 10 can also be of pouch type, for example. That means the anode 11 and the cathode 12 of the electrode assembly 10 consist of several flat foils that are stacked alternately to form a pile or a stack. Separator layers 18 are stacked between the foils of the anode 11 and the foils of the cathode 12. A bag or a pouch made of an electrically insulating material surrounds the electrode assembly 10 such that the electrode assembly 10 is electrically insulated.

The anode 11 contains an anode active material 21 formed as a flat foil and an anode current collector 23 formed as a flat foil. The anode active material 21 and the anode current collector 23 are attached to one another. The anode current collector 23 is electrically conducting and is made of a metal, in particular of copper. The anode current collector 23 is electrically connected to the negative terminal 15 of the battery cell 2.

The cathode 12 contains a cathode active material 22 formed as a flat foil and a cathode current collector 24 formed as a flat foil. The cathode active material 22 and the cathode current collector 24 are attached to one another. The cathode current collector 24 is electrically conducting and is made of a metal, in particular of aluminium. The cathode current collector 24 is electrically connected to the positive terminal 16 of the battery cell 2.

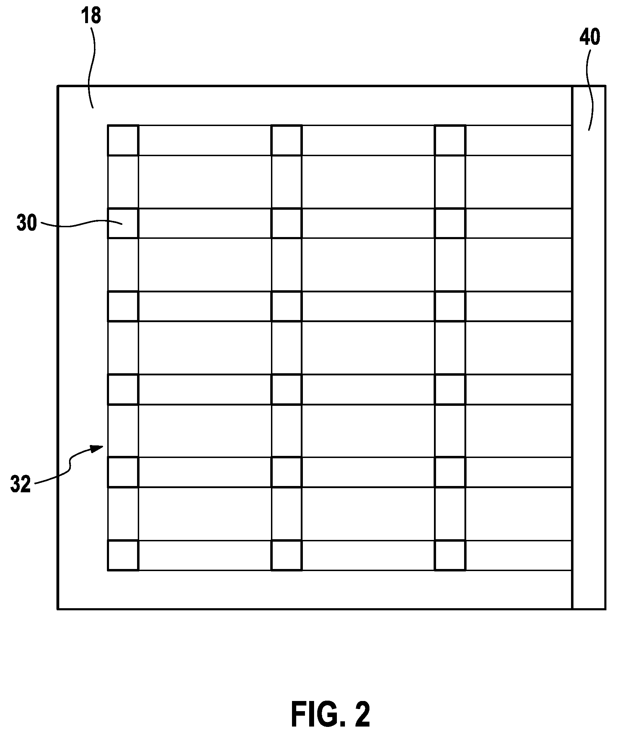

Sensor elements 30 that are not shown in figure 1 are integrated in the separator layer 18 of the electrode assembly 10. The sensor elements 30 serve for detecting defects in the electrode assembly 10. Presently, the sensor elements 30 are aligned in a matrix-like sensor arrangement 32. In figure 2, a schematic view at a sensor arrangement 32 containing a plurality of sensor elements 30 is given.

The sensor arrangement 32 comprises several rows and columns in which single sensor elements 30 are arranged. An evaluation unit 40 is also arranged on the separator layer 18. The evaluation unit 40 comprises logical or electronical circuits and receives measurement values from the sensor elements 30. The evaluation unit 40 checks the received measurement values. The evaluation unit 40 processes said measurement values to measurement data, and transmits said measurement data to a control unit that is not shown here.

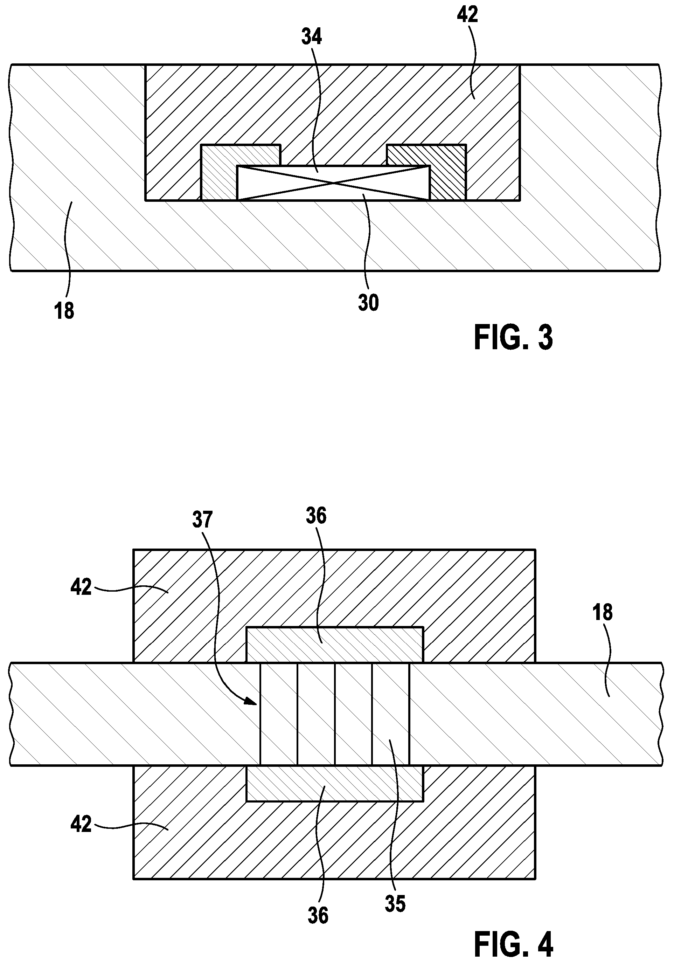

Figure 3 shows a schematic sectional view at a sensor element 30 that is a thermal sensor 34. The thermal sensor 34 serves for sensing temperature within the electrode assembly 10. The thermal sensor 34 is integrated into the separator layer 18. The thermal sensor 34 is surrounded by an encapsulation 42 that extends to the surface of the separator layer 18. Temperature of the thermal sensor 34 is measured, and corresponding measurement data is processed by the evaluation unit 40.

Figure 4 shows a schematic sectional view at a sensor element 30 that is a capacitive sensor 35. The capacitive sensor 35 includes two electrode plates 36 that are arranged on adjacent sides of the separator layer 18. The separator layer 18 represents a dielectric within the capacitive sensor 35. The electrode plates 36 protrude over the surface of the separator layer 18. The electrode plates 36 are surrounded each by an encapsulation 42 that extends over the surface of the separator layer 18.

Between the electrode plates 36 of the capacitive sensor 35, an approximately homogeneous electrical field 37 is established. In case of a short circuit in proximity of the capacitive sensor 35, the electrical field 37 is getting inhomogeneous and the capacity of the capacitive sensor 35 is changing. Said change of capacity is measured and corresponding measurement data processed by the evaluation unit 40.

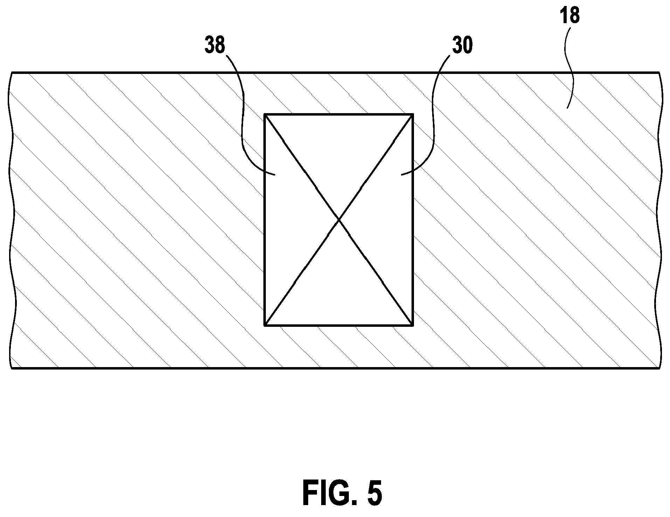

Figure 5 shows a schematic sectional view at a sensor element 30 that is a piezoelectric sensor 38. The piezoelectric sensor 38 serves for sensing force or pressure in the electrode assembly 10. Presently, the piezoelectric sensor 38 is completely integrated in the material of the separator layer 18. Alternatively, the piezoelectric sensor 38 may protrude to the surface or over the surface of the separator layer 18. When the piezoelectric sensor 38 detects a pressure or force, the piezoelectric sensor 38 generates a voltage that the evaluation unit 40 receives as a measurement value.

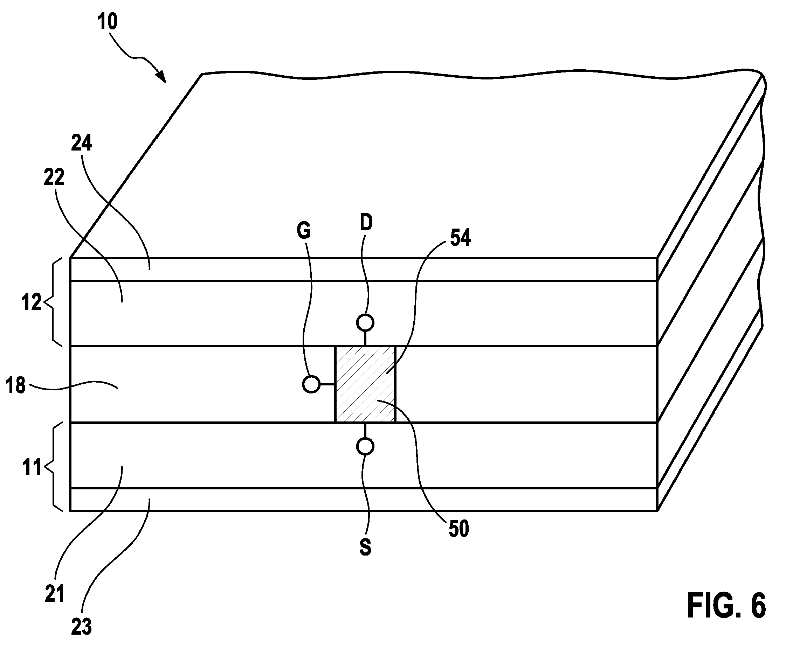

In figure 6, a schematic sectional view at an actuator element 50 through an electrode assembly 10 is given. Thereby, the actuator element 50 is a transistor actuator 54, in particular a field effect transistor (FET). The transistor actuator 54 serves for generating a defect in the electrode assembly 10, in particular a short circuit between the anode 11 and the cathode 12, for test purpose.

Presently, the transistor actuator 54 is integrated into the separator layer 18 of the electrode assembly 10 such that surfaces of the transistor actuator 54 align with adjacent surfaces of the separator layer 18. Hence, the surfaces of the actuator element 50, in particular electrode areas of the transistor actuator 54, are in electrical contact with the anode active material 21 and with the cathode active material 22.

The anode current collector 23 is placed on the anode active material 21 opposite to the separator layer 18. The anode current collector 23 and the anode active material 21 form the anode 11 of the electrode assembly 10. The cathode current collector 24 is placed on the cathode active material 22 opposite to the separator layer 18. The cathode current collector 24 and the cathode active material 22 form the cathode 12 of the electrode assembly 10.

Presently, the transistor actuator 54 is, as mentioned already, a field effect transistor (FET) having a gate G, a drain D and a source S. The drain D is in electric contact with the cathode active material 22, and the source S is in electric contact with the anode active material 21. In passive state, that means in absence of a control voltage at the gate G the transistor actuator 54 represents a relatively high resistance between the drain D and the source S.

When a control voltage is applied to the gate G, the transistor actuator 54 is activated and represents a relatively low resistance, respectively a short circuit, between the drain D and the source S. Hence, the transistor actuator 54 operates a short circuit between the anode active material 21 and the cathode active material 22.

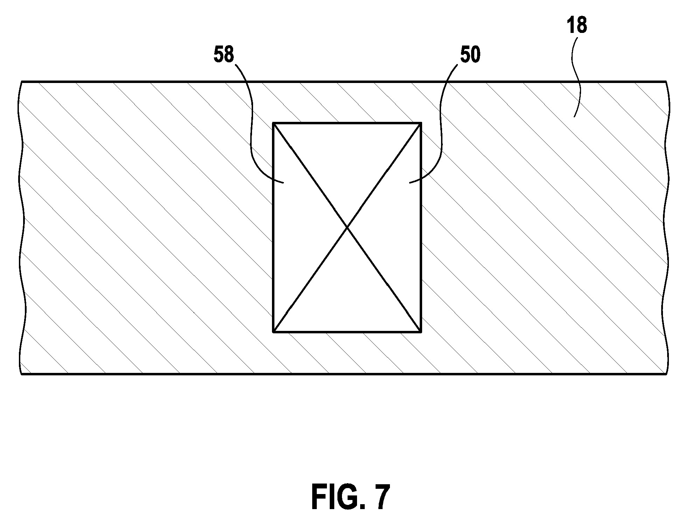

Figure 7 shows a schematic sectional view at an actuator element 50 that is a piezoelectric actuator 58. The piezoelectric actuator 58 is placed between the anode 11 and the cathode 12 and serves for generating a defect in the electrode assembly 10, in particular a force or pressure between the anode 11 and the cathode 12, for test purpose.

Presently, the piezoelectric actuator 58 is completely integrated in the material of the separator layer 18. Alternatively, the piezoelectric actuator 58 may protrude to the surface or over the surface of the separator layer 18. When applying a voltage to the piezoelectric actuator 58, the piezoelectric actuator 58 elongates in a direction perpendicular to the surfaces of the separator layer 18. Hence, the piezoelectric actuator 58 generates local pressure or local force on the anode 11 and on the cathode 12.

A plurality of actuator elements 50 can be aligned in a matrix-like actuator arrangement, similar to the sensor elements 30 that are aligned in a matrix-like sensor arrangement 32. The actuator elements 50 within the matrix-like actuator arrangement may all be of same type, in particular piezoelectric actuators 58 or transistor actuators 54. The matrix-like actuator arrangement may also comprise actuator elements 50 of different types, for example piezoelectric actuators 58 and transistor actuators 54.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings and those encompassed by the attached claims. The embodiments were chosen and described in order to explain the principles of the invention and its practical applications, to thereby enable others skilled in the art to utilize the invention and various embodiments with various modifications as are suited to the particular use contemplated.

## Claims

1. Battery cell (2), comprising
at least one electrode assembly (10), containing
an anode (11) and a cathode (12) that are divided from one another by means of a separator layer (18), and
at least one sensor element (30) for detecting defects in the electrode assembly (10),
**characterised in that**
the at least one sensor element (30) is at least partially integrated in the separator layer (18).

2. Battery cell (2) according to claim 1, **characterised in that**
a plurality of sensor elements (30) is aligned in a matrix-like sensor arrangement (32).

3. Battery cell (2) according to claim 2, **characterised in that**
an evaluation unit (40) for evaluating measurement data received from the sensor elements (30) is arranged on the separator layer (18). logical circuit

4. Battery cell (2) according to one of the preceding claims, **characterised in that**
the at least one sensor element (30) is a thermal sensor (34) sensing temperature in the electrode assembly (10).

5. Battery cell (2) according to one claims 1 to 3, **characterised in that**
the at least one sensor element (30) is a capacitive sensor (35) sensing electrical field in the electrode assembly (10).

6. Battery cell (2) according to one claims 1 to 3, **characterised in that**
the at least one sensor element (30) is a piezoelectric sensor (38) sensing force in the electrode assembly (10).

7. Battery cell (2) according to one of the preceding claims, **characterised in that**
at least one actuator element (50) for generating defects in the electrode assembly (10) is at least partially integrated in the separator layer (18).

8. Battery cell (2) according to claim 7, **characterised in that**
a plurality of actuator elements (50) is aligned in a matrix-like actuator arrangement.

9. Battery cell (2) according to one claims 7 to 8, **characterised in that**
the at least one actuator element (50) is a transistor actuator (54) generating a shortcut within the electrode assembly (10).

10. Battery cell (2) according to one claims 7 to 8, **characterised in that**
the at least one actuator element (50) is a piezoelectric actuator (58) generating force within the electrode assembly (10).

11. Usage of a battery cell (2) according to one of the preceding claims,
in an electric vehicle (EV), in a hybrid electric vehicle (HEV), in a plug-in hybrid vehicle (PH EV) or in a test laboratory.
